# EUROPEAN PATENT SPECIFICATION

(11) **EP 0 598 006 B1**
(45) Date of publication and mention of the grant of the patent: **20.11.1996**
(21) Application number: 92917243.5
(22) Date of filing: 03.08.1992
(51) Int. Cl.: B23K 31/02, B44C 1/22, H05K 3/00, B23K 1/00, H01L 21/48

(54) **SOLDER PLATE REFLOW METHOD FOR FORMING A SOLDER BUMP ON A CIRCUIT TRACE**
AUFSCHMELTZLÖTSVERFAHREN ZUM BILDEN VON EINEM LÖTHOCKER AUF EINER PRINTPLATTE
PROCEDE DE REFUSION DE PLAQUE DE SOUDURE SERVANT A FORMER UNE BOSSE DE SOUDURE SUR UN RUBAN DE CIRCUIT

(30) Priority: 05.08.1991 US 740271; 05.08.1991 US 740272
(43) Date of publication of application: 25.05.1994
(73) Proprietor: MOTOROLA, INC., Schaumburg, IL 60196 (US)
(72) Inventor: MOORE, Kevin, D., Schaumburg, IL 60194 (US); STAFFORD, John, W., St. Charles, IL 60174 (US); BECKENBAUGH, William, M., Barrington, IL 60010 (US); CHOLEWCZYNSKI, Kenneth, Streamwood, IL 60107 (US)
(74) Representative: Hudson, Peter David
(86) International application number: US9206456
(87) International publication number: WO9302831

(56) References cited:
- WO-A-87/01509
- US-A- 3 429 040
- US-A- 4 978 423

## Description

This invention relates to a method for forming a solder-bumped circuit trace on a printed circuit board or the like. More particularly, this invention relates to such method comprising reflow of a thin solder plate deposited on a circuit trace to cause the solder to coalesce to form a solder bump.

In the manufacture of a microelectronic package, it is known to mount a integrated circuit component onto a printed circuit board by solder bump interconnections. For this purpose, the board includes a copper circuit trace disposed on a dielectric substrate. To mount the component, a solder bump is attached to a bond pad on the component, typically by placing a preformed microsphere of the solder alloy on the pad and heating to reflow the solder. The bumped component is assembled with the board such that the bump rests against the trace at a predetermined site. The assembly is heated to reflow the solder so that, upon cooling to resolidify the solder, the solder is bonded to the trace as well as the component pad to physically join the component to the board and also to electrically connect the component to the trace for conducting electrical signals to and from the component for processing.

In the formation of solder bump interconnections, it has been proposed to apply a solder bump to the trace at the attachment site to provide additional solder in forming the interconnection. Also, as is known, it is convenient to apply the solder to a printed circuit board by electroplating. However, electroplating produces a generally uniform plate, in contrast to a solder bump that provides an enlarged mass at the site. Thus, there remains a need for an improved method for forming a solder bump on a circuit trace at a designated site.

### Summary of the Invention

This invention contemplates a method for forming a solder-bumped circuit trace that includes depositing onto the trace a thin plate of solder alloy and reflowing the solder alloy to form a bump.

In one aspect of this invention, a method is provided for forming a solder bump on a circuit trace affixed to a dielectric substrate comprising fabricating a circuit trace of a solder-wettable metal, said circuit trace comprising a first linear section and a second linear that intersects the first linear section at an intersection such that the angle therebetween is between about 45 degrees and 135 degrees, applying to the circuit trace an outer plate composed of a solder alloy and having a uniform thickness, and heating the outer plate at a temperature effective to melt the solder alloy and to draw molten solder alloy onto the intersection from the adjacent section to form a solder bump.

In another aspect of this invention, a method is provided for forming a solder bump on a circuit trace affixed to a dielectric substrate, comprising fabricating a circuit trace of a solder-wettable metal, said circuit trace comprising a terminal pad and a runner section connected to the terminal pad, said runner section have a section width adjacent to the terminal pad, said terminal pad having a width greater than the section width, applying an outer plate composed of a solder alloy to the circuit trace such that the outer plate overlies the runner section and the terminal pad, said outer plate having a uniform thickness, and heating the outer plate at a temperature effective to melt the solder alloy and to draw molten solder alloy onto the terminal section from the runner section to form a solder bump.

The width of the runner is suitably less than 500 microns and preferably between 50 and 150 microns. The terminal pad has a width, measured parallel to the runner width, that is greater than the runner width.

In either event, the trace is formed of a solder-wettable metal, most commonly copper. Prior to reflow, the trace includes a thin, outer plate composed of the solder alloy and having a uniform thickness. Thereafter, when the trace is heated to melt the solder layer, it is surprisingly found that the solder alloy coalesces either at the intersection or at the enlarged pad, to form the desired bump. In a preferred embodiment, the solder layer is deposited by electroplating to a thickness between about 10 and 25 microns and is reflowed to form a bump having a height greater than 40 microns and preferably between 60 and 80 microns.

The printed circuit board may be manufactured by applying a copper plate onto a dielectric substrate and thereafter applying a photolithographic mask or the like onto the plate. The mask defines a opening that exposes the copper at the trace, but covers the copper plate on the region adjacent to the trace. The masked copper plate is immersed in an electroplating bath containing dissolved tin and lead ions and cathodically biased to codeposit tin and lead metal onto the exposed copper to form a thin solder plate. Thereafter, the mask is removed, and the plate is immersed in a copper etching solution. The solder coating protects the underlying trace copper, while the solution etches the exposed copper to define the trace. The trace is then heated to reflow the solder to form the bump.

Thus, this invention provides a convenient method for forming a solder bump on a circuit trace. The bump is formed from a thin solder plate, thereby reducing the plating time. The solder plate also advantageously serves as an etch mask prior to reflow, allowing the circuit trace to be defined and the solder deposited using but a single photolithographic mask. Even though the solder is deposited as a thin plate, when the trace is subsequently heated to melt the solder alloy, the solder nevertheless coalesces to form a bump of a sufficient mass for use, for example, in attaching a component by solder bump interconnection.

### Description of the Drawings

The present invention will be further illustrated with reference to the accompanying drawings wherein:
FIG. 1 is a partial plan view of a printed circuit board showing a circuit trace adapted for forming a solder bump in accordance with this invention.
FIG. 2 is a cross-sectional view of the printed circuit board in FIG. 1, taken along line 2-2, showing a solder-plated trace prior to reflow.
FIG. 3 is a cross-sectional view of the circuit trace in FIG. 2 following reflow of the solder plate to form a bump.
FIG. 4 is a partial plan view of a printed circuit board showing a alternate embodiment of a circuit trace for forming a solder bump in accordance with this invention.
FIG. 5 is a partial plan view of a printed circuit board showing still another embodiment of a circuit trace for forming a solder bump in accordance with this invention.
FIG. 6 is a partial plan view of a printed circuit board showing still another embodiment of a circuit trace for forming a solder bump in accordance with this invention.
FIG. 7 is a plan view of a printed circuit board showing terminals for forming solder bumps thereon in accordance with this invention.
FIG. 8 is a cross-sectional view of the printed circuit board in FIG. 1, taken along line 2-2, showing a terminal prior to solder reflow;
FIG. 9 is a cross-sectional view of the terminal in FIG. 2 following reflow of the solder alloy to form a bump.
FIG. 10 is an electron photomicrograph showing a solder bump formed on a printed circuit board in accordance with this invention.
FIG. 11 is a perspective view of a terminal on a printed circuit board having an alternate configuration suitable for forming a solder bump in accordance with this invention; and
FIG. 12 is a perspective view of a terminal on a printed circuit board showing still another configuration suitable for forming a solder bump in accordance with this invention.

### Detailed Description of the Invention

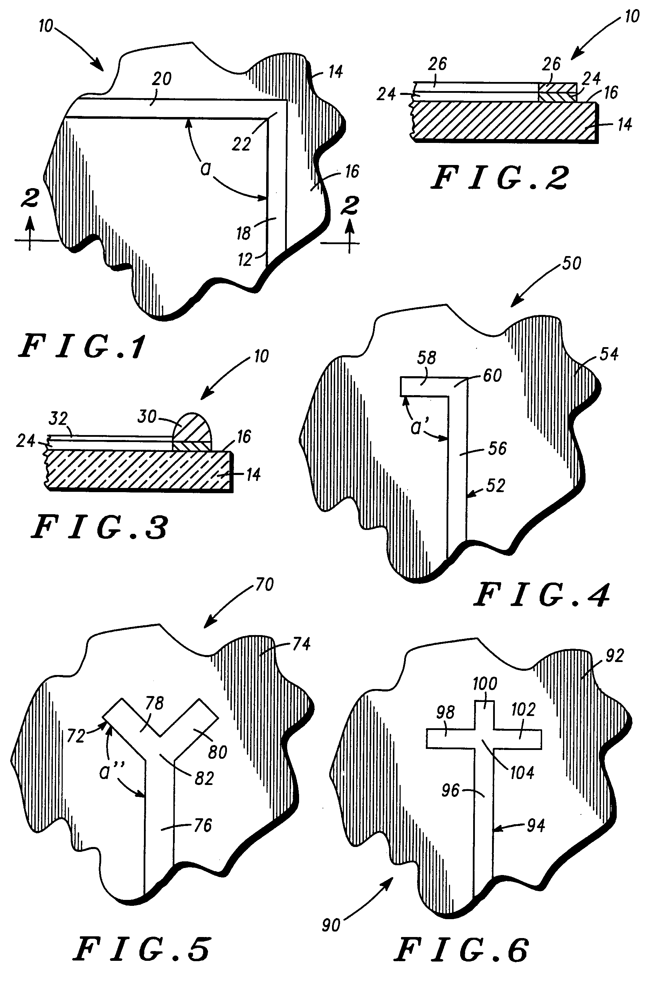

In a first preferred embodiment, referring to FIGS. 1-3, the method of this invention is employed to form a printed circuit board 10 having a solder-bump circuit trace 12. Printed circuit board 10 comprises a dielectric substrate 14 of the type referred to as an FR4 card and composed of an epoxy resin and glass fiber laminate. Substrate 14 has a planar major surface 16 to which is affixed circuit trace 12. For purposes of illustrating the features of this invention, board 10 is only partially depicted in the figures, it being understood that the depicted region constitutes but a minor proportion of the total area and that circuit trace 12 extends onto other regions of the board for conducting electrical signals for processing. In accordance with this invention, circuit trace 12 comprises a first linear section 18 and a second linear section 20, each having generally uniform width of about 100 microns. Sections 18 and 20 are arranged on surface 16 to intersect at an intersection designated generally at 22 and such that the angle between the sections is a right angle, i.e., 90 degrees.

Referring to FIG. 2, in accordance with the method of this invention, circuit trace 12 is initially formed of two coextensive metal layers 24 and 26. Layer 24 lies immediately adjacent substrate surface 16 and is formed of metallic copper having high electrical conductivity conducive to conducting electrical signals. Copper layer 24 is coated by a thin layer 26 composed of electroplated tin-lead solder alloy.

Printed circuit board 10 is manufactured by patterning a copper plate to define trace 12, including intersection sections 18 and 20, and electroplating solder onto the trace. Accordingly, a copper plate is initially applied to dielectric substrate 14 to completely cover surface 16. Thus, the plate includes a region for forming layer 24 of trace 12 and an adjacent region about trace 12. A suitable copper-plated board is readily commercially available and features a copper plate having thickness of about 17 microns. A film of photoimageable polymer material is applied to the copper plate and selectively irradiated to develop the polymer to form a photoresist mask. The mask is about 25 microns thick and covers the copper plate region about the trace and defines an opening whereat the trace layer 24 is exposed.

The masked board is immersed in a tin-lead plating solution and cathodically biased to deposit solder alloy onto the exposed copper trace. A suitable plating bath comprises, in water, 56.3 grams per liter tin, added as concentrated stannous fluoborate solution; 26.3 grams per liter lead, added as concentrated lead fluoborate solution, 99.8 grams per liter fluoboric acid; 26.3 grams per liter boric acid and 19.5 grams per liter liquid peptone. The masked board is immersed in the bath at ambient temperature spaced apart from a tin-lead counterelectrode. An electrical potential is applied to the copper plate to negatively bias the copper relative to the counterelectrode and codeposit metallic tin and metallic lead onto the exposed copper surface. One advantage of plating the tin-lead deposited onto the copper plate prior to removing the unwanted copper about the trace is that the continuous plate facilitates distribution of the plating current to produce a uniform electrodeposit. The resulting plate is composed of about 40 percent lead and the balance tin and has a thickness of about 20 microns. The plate thickness is preferably less than the thickness of the mask, so that plating is confined to the opening above the trace and does not extend upon the mask surface.

Following plating, the board is immersed in an alkaline solution to strip the photoresist mask, thereby exposing the copper plate region about the solder-coated trace. The board is immersed in an aqueous copper-etching solution containing ammonium persulfate, following by a water rinse. The etching solution removes the exposed copper. However, the tin-lead alloy is resistant to attack by the etching solution and acts as a mask to protect the underlying copper trace. In this manner, the unwanted copper is removed from about the trace to complete fabrication of the solder-plated trace depicted in FIG. 2 and featuring the copper plate 24 coated with the uniform, thin solder plate 26.

The printed circuit board having the dual-layer trace 12 is heated to reflow the solder to form the desired bump on intersection 22. A flux composed of amine hydrochloride and amine hydrobromide in isopropyl alcohol vehicle is applied to the solder plate surface. The board is immersed in hot polyoxyalkylene glycol bath at 250°C for 15 seconds. It was found that during immersion, the solder alloy melted and reflowed to draw solder from the sections onto intersection 22, thereby forming a bump 30 shown in FIG. 3. Following reflow, a residual solder film 32 remains on sections 18 and 20, but the thickness is significantly reduced compared to the initial film. Bump 30 has a height greater than 40 microns and preferably between 60 and 80 microns. Thus, bump 30 is particularly well suited for use in forming a solder bump interconnection to attach an electrical component to printed circuit board 10.

In the embodiment depicted in FIG. 1, sections 18 and 20 extend an indefinite length from intersection 22. This arrangement is particularly advantageous for allowing electrical signals to be conducted from a component attached to intersection 22, using bump 30, to or from distinct portions of the electrical circuit. However, the method of this invention is not limited to traces wherein both linear sections are active leads for the electrical circuit, but may be employed to produce a solder bump at an intersection wherein only one section is connected to the circuit.

Referring to FIG. 4, a printed circuit board 50 comprises a circuit trace 52 having an alternate configuration suitable for forming a solder bump thereon in accordance with the method of this invention. Trace 52 is disposed on a planar dielectric substrate 54 similar to substrate 14 in FIG. 1. Trace 52 comprises a first linear section 56 and a second linear section 58 that intersect at a right angle a' to form an intersection indicated generally at 60. In this embodiment, linear section 56 extends beyond the region depicted in FIG. 4 for connection to remote electrical features on board 50 to provide an active lead for conveying electrical signals to and from intersection 60. However, second section 58 is shortened and, except through the connection through lead 56, is not otherwise connected to the electrical circuit. As depicted in FIG. 4, trace 52 comprises a copper layer immediately overlying substrate 54 and a thin, uniform tin-lead solder electroplate. That is, trace 52 is shown following patterning of the copper layer and electrodeposition of the thin solder plate in a condition similar to FIG. 2, but prior to reflow of the solder alloy. Thereafter, trace 52 is heated, for example, by immersion in a hot oil bath, to melt the outer solder plate, whereupon the molten solder is drawn onto intersection 60 from the adjacent sections to form a solder bump.

The size of the bump formed during reflow is believed to be principally determined by the surface tension of the molten alloy and is independent of the length of the adjacent sections, provided that sufficient molten alloy is available for forming the bump. Thus, for linear sections of comparable widths, the size of the bump formed at intersection 60 of trace 52 in FIG. 4 is believed to be equal to the bump formed at intersection 22 of trace 12 in FIG. 1, with additional molten metal being drawn as needed from section 56 to compensate for any deficiency in the volume of metal drawn from section 58.

Referring to FIG. 5, in still another embodiment of this invention, a printed circuit board 70 includes a Y-shaped trace 72 suitable for forming a bumped intersection in accordance with this invention. Trace 72 is affixed to a dielectric substrate 74 and includes a first section 76 that extends for a remote connection to other electrical features on board 70 so as to act as an active lead for the electrical circuit. Trace 72 further comprises shortened sections 78 and 80 that intersect trace section 76 at an intersection 82. Sections 76, 78 and 80 are disposed equiangularly about intersection 82 such that each angle a'' between adjacent sections is 120 degrees. Trace 72 is shown prior to reflow and comprises an underlying copper layer immediately adjacent substrate 74 and a uniform, thin electroplate of tin-lead solder alloy, similar to trace 12 in FIG. 2. Thereafter, the trace is heated to melt the outer solder plate, whereupon the solder coalesces at intersection 82 to form a solder bump. In this embodiment, the two shortened sections 78 and 80 increase the volume of solder adjacent intersection 82 to be drawn by capillary action for forming the bump.

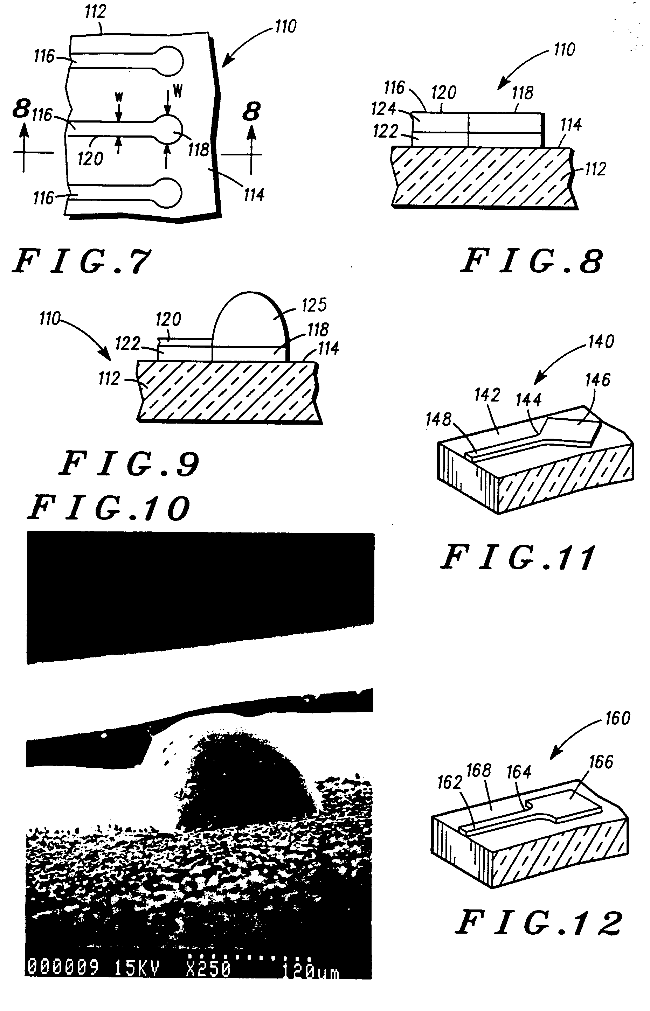

FIG. 6 shows yet another embodiment of a trace configuration suitable for forming a solder bump in accordance with this invention. A printed circuit board 90 comprises a dielectric substrate 92 having affixed thereto a trace 94. Trace 94 comprises a first linear section 96 that extends for connection to remote features of the electrical circuit to serve as an active lead. In addition, trace 94 includes three shortened linear sections 98, 100 and 102 that intersect section 96 and each other at an intersection designated generally at 104. The sections 96, 98, 100, and 102 are disposed equiangularly about intersection 104 so as to provide right angles between adjacent sections. The trace 94 is depicted in the initial plated condition prior to reflow anc comprises an underlying copper layer immediately adjacent substrate 92 ad an outer solder electroplate of uniform thickness overlying each section. Thereafter, trace 94 is heated, for example, by immersion in an oil bath, to reflow the solder plate, whereupon the solder is drawn by capillary forces from section 96, 98, 100, and 102 to coalesce at intersection 104 to form a solder bump. The embodiment in FIG. 6 is particularly advantageous for providing the preferred right angle arrangement between adjacent sections while increasing the volume of solder adjacent the intersection 104.

In the aforedescribed embodiments, the surprising formation of the solder bump is found to occur at an intersection between a first and a second linear section of a circuit trace. The method is particularly suitable for use with sections having widths less than 500 microns, such as is commonly employed in designing circuit traces. The preferred section widths is between about 50 and 150 microns. In these embodiment, sections having equal widths were utilized in forming the bumps. However, sections having different widths may be employed, for example, as necessary to accommodate other design considerations for the electrical circuit. It is believed that optimum conditions for bump formation during reflow are provided by sections arranged so that the angle therebetween is a right angle. However, conditions for forming a suitable bump exist where the angle between the sections is between about 45 degrees and 135 degrees.

In another embodiment of the invention, referring to FIGS. 8-10, the method of this invention is employed to form a printed circuit board 110 having a plurality of solder-bumped terminals for mounting an integrated circuit die component by solder bump interconnections. Printed circuit board 110 comprises a dielectric substrate 112 similar to board 10 in FIGS.1-3. Board 110 further includes a plurality of terminal sections 116 affixed to a planar surface of substrate 112 and surrounded by an adjacent bare region 114. In accordance with this embodiment, each terminal section 116 comprises an enlarged circular terminal pad 118 connected to a linear runner section 120. Runner section 120 extends radially from the circular pad 118 and has a generally uniform width w of preferably about 100 microns. In the preferred embodiment, terminal pad 118 has a diameter W of about 150 microns.

Referring to FIG. 8, in accordance with the method of this invention, each terminal section 116 is initially fabricated comprising two coextensive metal layers 122 and 124. Layer 122 lies immediately adjacent substrate 112 and is preferably formed of metallic copper having high electrical conductivity conducive to conducting electrical signals. Copper layer 122 is coated by thin layer 124 preferably composed of electroplated tin-lead solder alloy. Printed circuit board 110 is manufactured by masking a copper plate to define the trace, removing the mask to expose the surrounding copper, and etching the exposed copper, whereupon the solder plate serves as a mask in defining the trace, utilizing the process as described for FIG. 1-3.

As initially formed, the printed circuit board comprises a uniform, thin solder plate overlying the trace and is heated to reflow the solder to form the desired bumps. The board is immersed in hot polyoxyalkylene glycol bath at 250 °C for 15 seconds. It was found that during immersion the solder alloy melted and reflowed to draw solder from the linear runner section 120 and accumulate the solder on terminal pad 118, thereby forming a bump 125 shown in FIG. 9. Following reflow, a residual solder film 126 remains on runner 120, but having a thickness substantially reduced compared to the initial film.

FIG. 10 is an electron photomicrograph of a solder bump on a terminal formed in accordance with this embodiment. The height of the bump relative to the copper trace was about 60 microns. Thus, the bump was deemed to be particularly well suited for use in forming solder bump interconnections to attach an electrical component to the printed circuit board.

Therefore, this embodiment also provides a solder reflow method for producing a solder bump on a terminal pad of a copper trace which requires but a single photoresist mask to define the trace including the terminal pad, which permits the solder to be deposited by electroplating ad subsequently used as a mask during etching of the trace, which avoids use of a solder stop by creating conditions that coalesce the solder onto the pad from the adjacent section, and which reduces the plating time by depositing a relatively thin plate and reflowing to accumulate the desired mass for the bump. While not limited to any particular theory, the surprising formation of the bump during reflow is attributed to the particular configuration of the terminal that features an enlarged pad connected to a relatively narrow runner and is effective to cause the molten solder during reflow to be drawn by capillary forces onto the pad from the adjacent runner. In designing the terminal, it is desired to optimize the ratio of the runner width to the pad width to minimize the required thickness of the solder plate while coalescing sufficient solder during reflow to produce the desired bump size. As used herein, the runner width refers to the width of the runner section immediately adjacent the enlarged pad, whereas the pad width refers to the maximum dimension of the pad measured parallel to the runner width. This method is believed to be particularly suitable for use with runners having widths less than about 500 microns, such as is commonly employed in designing circuit traces. The preferred runner width is between about 50 and 150 microns. A pad width, that is, the diameter for the described circular pad, of at least 1.2 times the adjacent runner width is effective in drawing sufficient solder to form a suitable bump. Preferably, the pad width is between about 1.2 and 2.0 times the runner width.

Referring to FIG. 11, in still another embodiment, a printed circuit board 140 includes a square pad 146 that is in suitable fashion to provide a enlarged area for coalescence of the solder alloy to form a bump. Board 140 including an epoxy-glass substrate 142 and a terminal section 144 that include pad 146 and an adjacent runner 148 that extends from a corner of the square pad. To better illustrate the terminal pad shape, the terminal section is depicted with the solder plate, but prior to reflow to form the bump and thus includes a copper trace and a thin, uniform solder layer similar to the terminal shown in FIG. 8. During reflow, solder is drawn from the runner section onto the terminal pad to produce a generally semispherical bump.

In still a further embodiment, FIG. 12 shows a printed circuit board 160 comprising an epoxy-glass substrate 162 and having a terminal 164 also suitably configured for the practice of this invention. Terminal 164 comprises a generally rectangular pad 166 and an adjacent runner section 168 that extends from a side of pad 166. The terminal is depicted in the condition following elecrodeposition and prior to reflow, similar to the terminal depicted in FIG. 8, to better illustrate the pad configuration. During reflow, solder is drawn onto the terminal pad from the adjacent runner to produce the desired rounded bump.

A significant feature of this invention is the formation of the bump during reflow from a initial thin plate of solder alloy on the trace. While copper is most commonly selected for the trace metal because of its relative low cost and advantageous electrical properties including a low resistance conducive for conducting electrical signals, the terminal may be formed of any suitable metal that provides a solder-wettable surface, including, for example, nickel or gold, either applied directly onto the dielectric substrate or onto a copper or other metal base to provide an intermediate layer between the base and the solder. The solder layer may be formed of any suitable solder alloy. Typical solder alloys are formed predominantly of one or more metals selected from the group consisting of lead, tin and indium and include lead-base alloys containing about 5 weight percent tin and indium-base alloys containing about 30 percent lead. Preferably, the solder is composed of near-eutectic tin-lead alloy containing between about 35 and 45 percent lead. Although the solder is preferably deposited by electroplating, the plate may be formed by sputtering or any process suitable for applying a thin layer of the solder metal onto the trace.

In the described embodiments, reflow of the thin solder plate also left a residual film on the runner. It is desired to deposit a solder thickness adequate to provide sufficient molten alloy to maximize the bump size. Depending upon the intended application, the residual film on the runner may be advantageous, for example, to provide a protective coating. On the other hand, for a specific trace configuration, it may be desirable to minimize the initial solder deposit to reduce or eliminate the residual film. A solder plate having a thickness less than 25 microns provides sufficient metal during ring reflow for bump formation. Preferably, the initial solder plate thickness is between about 10 and 25 microns. For forming solder bump interconnections, it is desired to produce a bump having a height measured relative to the copper trace surface of at least 40 microns, and preferably between about 60 and 80 microns.

While this invention has been described in terms of certain embodiments thereof, it is not intended that it be limited to the above description but rather only to the extent set forth in the claims that follow. The embodiments of the invention in which an exclusive property or privilege is claimed are defined as follows.

## Claims

1. A method for forming a solder bump on a circuit trace (12) affixed to a dielectric substrate (14), comprising
fabricating a circuit trace (12) of a solder-wettable metal, said circuit trace comprising a first linear section (18) and a second linear section (20) that intersects the first linear section at an intersection (22) such that the angle therebetween is between about 45 degrees and 135 degrees,
applying to the circuit trace an outer plate (26) composed of a solder alloy and having a uniform thickness, and
heating the outer plate at a temperature effective to melt the solder alloy and to draw molten solder alloy onto the intersection from the adjacent section to form a solder bump (30).

2. A method for forming a solder bump on a circuit trace (116) affixed to a dielectric substrate (112), comprising
fabricating a circuit trace (112) of a solder-wettable metal, said circuit trace comprising a terminal pad (118) and a runner section (120) connected to the terminal pad, said runner section have a section width adjacent to the terminal pad, said terminal pad having a width greater than the section width,
applying an outer plate (122) composed of a solder alloy to the circuit trace such that the outer plate overlies the runner section and the terminal pad, said outer plate having a uniform thickness, and
heating the outer plate at a temperature effective to melt the solder alloy and to draw molten solder alloy onto the terminal section from the runner section to form a solder bump (125).

3. The method in accordance with claim 1 or 2 wherein the outer plate has a thickness less than about 25 microns.

4. The method in accordance with claim 1 or 2 wherein the solder bump has a height greater than about 40 microns.

5. The method in accordance with claim 1 or 2 wherein the outer plate has thickness between about 10 and 25 microns and the solder bump has a height between about 60 and 80 microns.

6. The method in accordance with claim 1 or 2 wherein the circuit trace is formed of copper metal and further wherein the outer plate is composed of a solder alloy comprising between about 35 and 45 weight percent lead and the balance substantially tin.

7. The method in accordance with claim 1 wherein the first linear section and the second linear section have a generally uniform width adjacent to the intersection that is less than 500 microns.

8. The method in accordance with claim 1 wherein at least one of said first linear section and said second linear section has a generally uniform width adjacent to the intersection that is between about 50 and 150 microns.

9. The method in accordance with claim 2 wherein the runner section has a section width less than 500 microns and the terminal pad has a width 1.2 times greater than the linear section width.

10. The method in accordance with claim 2 wherein the terminal pad width is between about 1.2 and 2.0 times the section width.

11. The method in accordance with claim 2 wherein the runner section has a section width between about 50 and 150 microns.

12. The method in accordance with claim 2 wherein the terminal pad is circular and the runner section extends radially from the terminal pad.

13. The method in accordance with claim 2 wherein the terminal pad is square and the runner section extends from a corner of the terminal pad.

14. The method in accordance with claim 2 wherein the terminal pad is rectangular and the runner section extends from a side of the terminal pad.

## Patentansprüche

1. Verfahren zum Bilden einer Lötmittel-Perle auf einer Schaltkreisspur (12), die mit einem dielektrischen Substrat (14) befestigt ist, das aufweist
Herstellen einer Schaltkreisspur (12) aus einem mit Lötmittel benetzbaren Metall, wobei die Schaltkreisspur einen ersten linearen Abschnitt (18) und einen zweiten linearen Abschnitt (20), der den ersten linearen Abschnitt an einer Schnittstelle (22) schneidet, so daß der Winkel dazwischen zwischen etwa 45 Grad und 135 Grad liegt, aufweist,
Aufbringen auf die Schaltkreisspur einer äußeren Plattierung (26), die aus einer Lötmittel-Legierung zusammengesetzt ist und eine gleichförmige Dicke aufweist, und
Aufheizen der äußeren Plattierung auf eine Temperatur, die dahingehend effektiv ist, die Lötmittel-Legierung zu schmelzen und die geschmolzene Lötmittel-Legierung auf die Schnittstelle von dem angrenzenden Abschnitt anzuziehen, um eine Lötmittel-Perle (30) zu bilden.

2. Verfahren zum Bilden einer Lötmittel-Perle auf einer Schaltkreisspur (116), die auf einem dielektrischen Substrat (112) befestigt ist, das aufweist
Herstellen einer Schaltkreisspur (112) aus einem mit Lötmittel benetzbaren Metall, wobei die Schaltkreisspur eine Anschlußfläche (118) und einen Schienenabschnitt (120), der mit der Anschlußfläche verbunden ist, aufweist, wobei der Schienenabschnitt eine Abschnittsbreite angrenzend an die Anschlußfläche besitzt, wobei die Anschlußfläche eine Breite größer als die Abschnittsbreite besitzt,
Aufbringen einer äußeren Plattierung (122), die aus einer Lötmittel-Legierung gebildet ist, auf die Schaltkreisspur derart, daß die äußere Plattierung den Schienenabschnitt und die Anschlußfläche überdeckt, wobei die äußere Plattierung eine gleichförmige Dicke besitzt, und
Aufheizen der äußeren Plattierung auf eine Temperatur, die zum Schmelzen der Lötmittel-Legierung und zum Anziehen geschmolzener Lötmittel-Legierung auf den Anschlußabschnitt von dem Schienenabschnitt effektiv ist, um eine Lötmittel-Perle (125) zu bilden.

3. Verfahren nach Anspruch 1 oder 2, wobei die äußere Plattierung eine Dicke geringer als etwa 25 Mikron besitzt.

4. Verfahren nach Anspruch 1 oder 2, wobei die Lötmittel-Perle eine Höhe größer als etwa 40 Mikron besitzt.

5. Verfahren nach Anspruch 1 oder 2, wobei die äußere Plattierung eine Dicke zwischen etwa 10 und 25 Mikron besitzt und die Lötmittel-Perle eine Höhe zwischen etwa 60 und 80 Mikron besitzt.

6. Verfahren nach Anspruch 1 oder 2, wobei die Schaltkreisspur aus Kupfer-Metall gebildet ist und wobei weiterhin die äußere Plattierung aus einer Lötmittel-Legierung zusammengesetzt ist, die zwischen etwa 35 und 45 Gewichtsprozent Blei und den Rest im wesentlichen Zinn aufweist.

7. Verfahren nach Anspruch 1, wobei der erste lineare Abschnitt und der zweite lineare Abschnitt eine im wesentlichen gleichförmige Breite angrenzend an die Schnittstelle besitzen, die geringer als 500 Mikron beträgt.

8. Verfahren nach Anspruch 1, wobei mindestens einer des ersten linearen Abschnitts und des zweiten linearen Abschnitts eine im wesentlichen gleichförmige Breite angrenzend an die Schnittstelle besitzt, die zwischen etwa 50 und 150 Mikron beträgt.

9. Verfahren nach Anspruch 2, wobei der Schienenabschnitt eine Abschnittsbreite geringer als 500 Mikron besitzt und wobei die Anschlußfläche eine Breite 1,2-mal größer als die Breite des linearen Abschnitts ist.

10. Verfahren nach Anspruch 2, wobei die Breite der Anschlußfläche zwischen etwa 1,2- und 2,0-mal der Abschnittsbreite entspricht.

11. Verfahren nach Anspruch 2, wobei der Schienenabschnitt eine Abschnittsbreite zwischen etwa 50 und 150 Mikron besitzt.

12. Verfahren nach Anspruch 2, wobei die Anschlußfläche kreisförmig ist und wobei sich der Schienenabschnitt radial von der Anschlußfläche erstreckt.

13. Verfahren nach Anspruch 2, wobei die Anschlußfläche quadratisch ist und sich der Schienenabschnitt von einer Ecke der Anschlußfläche aus erstreckt.

14. Verfahren nach Anspruch 2, wobei die Anschlußfläche rechtwinklig ist und sich der Schienenabschnitt von der Seite der Anschlußfläche aus erstreckt.

## Revendications

1. Procédé de formation d'une perle de soudure sur un ruban de circuit (12) attachée à un substrat isolant (14), comprenant
la fabrication d'un ruban de circuit (12) avec un métal mouillable de soudage, ledit ruban de circuit comprenant une première section linéaire (18) et une deuxième section linéaire (20) qui croise la première section linéaire au niveau d'une intersection (22) de sorte que l'angle formé entre les deux soit compris entre environ 45 degrés et 135 degrés,
l'application au ruban de circuit d'une plaque extérieure (26) composée d'un alliage de soudage et ayant une épaisseur uniforme, et
le chauffage de la plaque extérieure à une température efficace pour faire fondre l'alliage de soudage et étirer l'alliage de soudage fondu sur l'intersection depuis la section adjacente pour former une perle de soudure (30).

2. Procédé de formation d'une perle de soudure sur un ruban de circuit (116) attachée à un substrat isolant (112), comprenant
la fabrication d'un ruban de circuit (116) avec un métal mouillable de soudage, ledit ruban de circuit comprenant une pastille terminale (118) et une deuxième section de patin (120) connectée à la pastille terminale, ladite section de patin ayant une largeur de section adjacente à la pastille terminale, ladite section terminale ayant une largeur supérieure à la largeur de section,
l'application d'une plaque extérieure (122) composée d'un alliage de soudage au ruban de circuit de sorte que la plaque extérieure recouvre la section de patin et la pastille terminale, ladite plaque supérieure ayant une épaisseur uniforme, et
le chauffage de la plaque extérieure à une température efficace pour faire fondre l'alliage de soudage et étirer l'alliage de soudage fondu sur la section terminale depuis la section de patin pour former une perle de soudure (125).

3. Procédé selon la revendication 1 ou 2, dans lequel la plaque extérieure a une épaisseur inférieure à environ 25 microns.

4. Procédé selon la revendication 1 ou 2, dans lequel la perle de soudure a une hauteur supérieure à environ 40 microns.

5. Procédé selon la revendication 1 ou 2, dans lequel la plaque extérieure a une épaisseur comprise entre environ 10 et 25 microns et la perle de soudure a une hauteur comprise entre environ 60 et 80 microns.

6. Procédé selon la revendication 1 ou 2, dans lequel le ruban de circuit est formé de métal cuivre et dans lequel, en outre, la plaque extérieure est composée d'un alliage de soudage comprenant environ 35 à 45 pour cent en poids de plomb, le reste étant essentiellement de l'étain.

7. Procédé selon la revendication 1, dans lequel la première section linéaire et la deuxième section linéaire ont une largeur généralement uniforme adjacente à l'intersection qui est inférieure à 500 microns.

8. Procédé selon la revendication 1, dans lequel au moins une parmi ladite première section linéaire et ladite deuxième section linéaire a une largeur généralement uniforme adjacente à l'intersection comprise entre environ 50 et 150 microns.

9. Procédé selon la revendication 2, dans lequel la section de patin a une largeur de section inférieure à 500 microns et la pastille terminale a une largeur 1,2 fois supérieure à la largeur de section linéaire.

10. Procédé selon la revendication 2, dans lequel la largeur de la pastille terminale est comprise entre environ 1,2 et 2,0 fois la largeur de la section.

11. Procédé selon la revendication 2, dans lequel la section de patin a une largeur de section comprise entre environ 50 et 150 microns.

12. Procédé selon la revendication 2, dans lequel la pastille terminale est circulaire et la section de patin s'étend de façon radiale à partir de la pastille terminale.

13. Procédé selon la revendication 2, dans lequel la pastille terminale est carrée et la section de patin s'étend à partir d'un coin de la pastille terminale.

14. Procédé selon la revendication 2, dans lequel la pastille terminale est rectangulaire et la section de patln s'étend à partir d'un côté de la pastille terminale.
